# EUROPÄISCHE PATENTSCHRIFT

(11) **EP 2 783 397 B1**
(45) Veröffentlichungstag und Bekanntmachung des Hinweises auf die Patenterteilung: **27.12.2017**
(21) Anmeldenummer: 12799526.4
(22) Anmeldetag: 23.11.2012
(51) Int. Cl.: H01L 31/048, H02G 3/08

(54) **GENERATORANSCHLUSSKASTEN FÜR PHOTOVOLTAIKANLAGEN**
GENERATOR CONNECTION BOX FOR PHOTOVOLTAIC INSTALLATIONS
COFFRET DE CONNEXION DE GÉNÉRATEUR POUR INSTALLATIONS PHOTOVOLTAÏQUES

(30) Priorität: 23.11.2011 DE 102011119173
(43) Veröffentlichungstag der Anmeldung: 01.10.2014
(73) Patentinhaber: Phoenix Contact GmbH & Co. KG, 32825 Blomberg (DE)
(72) Erfinder: THÖRNER, Carsten, 49324 Melle (DE); SENGER, Andreas, 33184 Altenbeken (DE)
(74) Vertreter: Blumbach Zinngrebe
(86) Internationale Anmeldenummer: PCT/EP2012/073538
(87) Internationale Veröffentlichungsnummer: WO 2013/076285

(56) Entgegenhaltungen:
- EP-A2- 2 146 383
- WO-A1-2009/101096
- DE-U1-202008 007 846
- US-A1- 2010 039 781
- Mersen: "Combiner Boxes for Solar Arrays", , 9. März 2011 (2011-03-09), XP055053328, Gefunden im Internet: URL:http://ep-ca.mersen.com/pdf/Solar-Arra y-Combiner-Boxes.pdf [gefunden am 2013-02-13]

## Beschreibung

### Gebiet der Erfindung

Die Erfindung betrifft einen Generatoranschlusskasten für einen Photovoltaikgenerator sowie Eingangsmodule zum Einbau in einen Generatoranschlusskasten.

### Hintergrund der Erfindung

Bei einem Photovoltaikgenerator zur Erzeugung elektrischer Leistung aus Sonnenlicht wird der Gesamtgenerator typischerweise in einzelne Stränge bestehend aus mehreren seriell geschalteten photovoltaischen Solarmodulen unterteilt. Die einzelnen Stränge des Photovoltaikgenerators wiederum sind zueinander parallel geschaltet.

Von jedem der zueinander parallel geschalteten Stränge wird typischerweise eine elektrische Verbindungsleitung zu einem Generatoranschlusskasten gelegt. Demgemäß werden die Leitungen aller Stränge in diesem Generatoranschlusskasten gebündelt.

Die einzelnen Photovoltaikgeneratorstranganschlussleitungen, kurz Strangleitungen, werden für gewöhnlich einzeln durch die Gehäusewand in den Generatoranschlusskasten geführt, und innerhalb des Generatoranschlusskastens an dort befindliche Bauteile angeschlossen. Die elektrische Verbindung an den Bauteilen wird dabei typischerweise durch eine Klemm- oder Schraubverbindung realisiert. Bei einer Vielzahl an Strangleitungen ist dies umständlich und erfordert bei deren Anschluss an die Bauteile des Generatoranschlusskastens einen erheblichen Installationsaufwand. Darüber hinaus ist auch eine Zugentlastung der Strangleitung ggf. schwierig umzusetzen.

Nach dem mit der Strangleitung verbundenen Bauteil sind in dem Generatoranschlusskasten ggf. weitere Bauteile zu installieren, beispielsweise Messbauteile für eine dort stattfindende Strangstrommessung, Verbindungsbauteile für eine Brückenverbindung von mehreren Strangleitungen oder auch ein Trennschalter zur Trennung des Gesamtgenerators von nachgeschalteten Komponenten, wie den Wechselrichtern zur Netzeinspeisung. Auch diese Bauteile sind aufwändig einzeln vom Installateur zu verkabeln.

Die Gebrauchsmusterschrift DE 20 2008 007 846 U1 zeigt eine Photovoltaikanlage mit einer Anschlussbox zum Verbinden von Solarzellen mit einem Wechselrichter. Die Anschlussbox weist ein Gehäuse auf, mehrere Sicherungen mit Sicherungskörpern und mehrere Anschlussklemmblöcke. Von den Solarmodulsträngen zur Anschlussbox führende Solarstromkabel sind an Steckverbinder der Anschlussbox anschließbar.

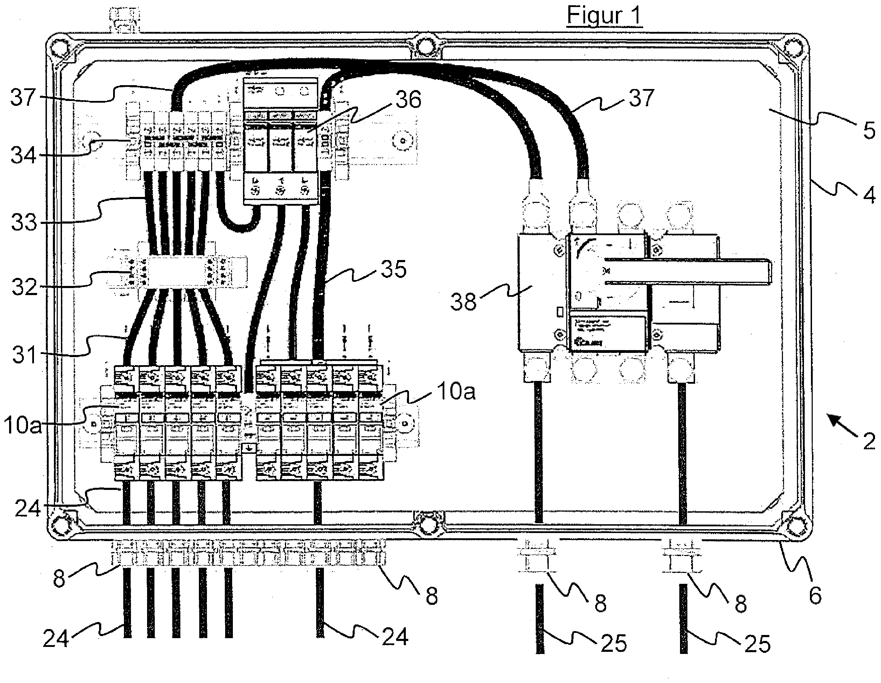

Figur 1 zeigt den Innenaufbau eines bekannten Generatoranschlusskastens. Die Strangleitungen 24 des Photovoltaikgenerators werden an Terminals von Eingangsmodulen 10a angeschlossen. Hierfür werden die Strangleitungen durch Öffnungen 8 in der umlaufenden Seitenwand 6 des Anschlusskastengehäuses 4 hindurchgeführt und im Inneren des Anschlusskastengehäuses 4 an die Terminals der Eingangsmodule 10a angeschlossen. Für jede Strangleitung wird also bereits ein eigenes Eingangsmodul 10a nur zum Zweck des Anschließens der Strangleitung benötigt.

Von den Eingangsmodulen 10a, an welche die Strangleitungen 24 jeweils desselben Poles des Photovoltaikgenerators angeschlossen sind, wird je eine elektrische Messmodulleitung 31 zu einem Messmodul 32 gelegt, mit welchem typischerweise eine Einzelstrangstrommessung durchgeführt wird. Vom Messmodul 32 aus wird wiederum für jeden anzuschließenden Strang des PV-Generators eine elektrische Brückungsmodulleitung 33 zu je einem Brückungsmodul 34 gelegt. Ein Brückungsmodul 34 wird zur Brückung der einzelnen PV-Stränge und somit zum Sammeln der erzeugten Strangströme eingesetzt.

Gegebenenfalls sind noch weitere elektrische Verbindungsleitungen im Generatoranschlusskasten angeordnet, beispielsweise für den Anschluss eines Haupttrennschalters 38 mittels einer Trennschalterleitung 37 oder zum Anschließen weiterer Module 36.

Durch die aufwändige Verbindung der Strangleitungen mit den Eingangsmodulen sowie Montage und elektrische Verbindung der Vielzahl an benötigten unterschiedlichen Modulen 10a, 32, 34, 36 im Generatoranschlusskasten entstehen insgesamt unnötige Zeit- und Kostenfaktoren, die der bisherige Stand der Technik nicht zufriedenstellend zu verringern vermag.

### Allgemeine Beschreibung der Erfindung

Die Erfindung hat sich daher die Aufgabe gestellt, die genannten Probleme zu lösen oder zu mindern.

Es ist insbesondere eine Aufgabe der Erfindung, einen Generatoranschlusskasten bereitzustellen, der eine schnelle und sichere Verbindung der Strangleitungen an die in dem Generatoranschlusskasten befindlichen Module ermöglicht und den Installationsaufwand für den Monteur minimiert.

Eine weitere Aufgabe der Erfindung ist es, einen Generatoranschlusskasten bereitzustellen, bei welchem der Verkabelungsaufwand innerhalb des Generatoranschlusskastens reduziert wird.

Noch eine Aufgabe der Erfindung ist es, Eingangsmodule bereitzustellen, welche einfach innerhalb des Generatoranschlusskastens zusammengeschaltet werden können, an die schnell und sicher Strangleitungen angeschlossen werden können und durch deren Verwendung der Installationsaufwand reduziert wird.

Die Aufgabe der Erfindung wird durch den Gegenstand der unabhängigen Ansprüche gelöst. Vorteilhafte Weiterbildungen der Erfindung sind in den Unteransprüche definiert.

Erfindungsgemäß weist ein Generatoranschlusskasten für einen Photovoltaikgenerator ein Anschlusskastengehäuse auf mit einer Rückwand, einer umlaufenden Seitenwand und einer Frontabdeckung. Die Rückwand weist ggf. Befestigungslöcher zum Befestigen des Generatoranschlusskastens am Montageort, beispielsweise an einer Hauswand oder an einem Traggestell, auf. Die umlaufende Seitenwand weist Öffnungen auf, um die in dem von dem Anschlusskastengehäuse umschlossenen Innenraum des Generatoranschlusskastens beherbergten Module mit Strangleitungen und anderen elektrischen Außenverbindungen zu verbinden.

Unmittelbar an der Innenseite der umlaufenden Seitenwand des Anschlusskastengehäuses sind Eingangsmodule angeordnet, derart, dass die Strangleitungen direkt von außen an einen Schnellverbinder des zugehörigen Eingangsmoduls anschließbar sind, ohne die Frontabdeckung öffnen zu müssen. Hiermit lassen sich innerhalb des Generatoranschlusskastens verlaufende Kabelstrecken der Strangleitungen vermeiden. Die Strangleitungen werden dabei direkt von außerhalb des Anschlusskastengehäuses an den Schnellverbinder des Eingangsmoduls angeschlossen.

Bevorzugt erstreckt sich der Schnellverbinder des Eingangsmoduls aus dem Innenbereich des Anschlusskastengehäuses durch die Öffnung in der umlaufenden Seitenwand hindurch in den Außenbereich. In dieser Ausführungsform wird die jeweilige Strangleitung außerhalb des Generatoranschlusskastens unmittelbar im Bereich der umlaufenden Seitenwand an den Schnellverbinder angeschlossen.

Mit anderen Worten kommt ein Eingangsmodul entweder an der Seitenwand zur Anlage oder es greift in die Öffnung der Seitenwand ein. Das heißt, dass das Eingangsmodul von innen an der oder in die Öffnung eingreifend angeordnet ist, so dass der Schnellverbinder des Eingangsmodul bereits beim Montieren des Eingangsmoduls in den Generatoranschlusskasten an der Öffnung anliegt oder in die Öffnung eingreift.

Der Schneliverbinder, der Teil des Eingangsmoduls ist, ist somit von außerhalb des Generatoranschlusskastens für einen direkten Anschluss der Strangleitung erreichbar, indem entweder der Schnellverbinder aus dem Generatoranschlusskasten herausragt oder dieser in der Öffnung zu liegen kommt, so dass die Strangleitung unmittelbar an das Eingangsmodul angeschlossen wird.

Zur leichten Erreichbarkeit des Innenbereichs des Generatoranschlusskastens kann die Vorderseite mit einer Frontseite in Form einer Tür versehen sein, die leicht geöffnet werden kann und damit einen Zugang zum Innenbereich darstellt. Auf eine Tür kann ggf. aber sogar verzichtet werden, da der Monteur nicht zwingend Zugang zum Innenbereich des Generatoranschlusskastens besitzen muss. Optional ist eine Tür vorgesehen, die nur von speziell autorisiertem Personal geöffnet werden kann.

Das unmittelbare Anschließen der Strangleitungen von außen an den Schnellverbinder minimiert die Montagezeiten und damit Kosten. Beispielsweise kann mittels einer einfachen Identifizierung der jeweiligen Anschlüsse, insbesondere durch eine Farbkodierung, das Anschließen der Strangleitungen an die Eingangsmodule des Generatoranschlusskastens ohne Zugang zum Innenbereich erfolgen. Das Risiko einer fehlerhaften Verdrahtung innerhalb des Generatoranschlusskastengehäuses kann hierdurch verringert werden. Ein Zugriff auf den inneren Bereich des Generatoranschlusskastens wird für diese Ausführungsform der Erfindung daher nicht benötigt.

Der Anschluss der Strangleitungen an die Eingangsmodule kann mittels der Schnellverbinder sogar ohne Werkzeug erledigt werden.

Die Schnellverbinder weisen insbesondere eine elektrische Isolierung und/oder kontakt- und berührungsgeschützte Anschlüsse auf. Im getrennten Zustand ausreichend kontakt- und berührungsgeschützte Anschlüsse können auch für den Fall, dass bereits eine elektrische Spannung an den Strangleitungen anliegt, was in der Regel der Fall ist, da die Solarmodule unmittelbar unter Aussetzung von Sonnenlicht mit der Stromproduktion beginnen, angeschlossen oder abgeklemmt werden. Das bedeutet, dass auch im laufenden Betrieb und/oder bereits mit angeschlossenen photovoltaischen Solarmodulen die Wartung eines oder mehrerer Photovoltaikstränge ermöglicht sein kann, ohne die übrige Anlage abzuschalten. Im Besonderen bedeutet es, dass die Gefahr eines Stromschlags, die von den elektrischen Anschlüssen für den Monteur ausgeht, verringert ist.

Das Anschlusskastengehäuse ist insbesondere nach Schutzklasse IP54 wassergeschützt und bevorzugt aus dielektrischem Material gefertigt.

Die jeweilige mit dem Anschlusskasten zu verbindende Strangleitung ist mit einem zu dem Schnellverbinder des Eingangsmoduls komplementären Schnellverbinder ausgerüstet. Dies ermöglicht eine besonders schnelle und einfache Verbindung von Strangleitung und Eingangsmodul im Generatoranschlusskasten, insbesondere wenn der Schnellverbinder der Strangleitung und der Schnellverbinder des Eingangsmoduls beiderseits vormontiert sind.

Zur Verbindung eines abisolierten Leiterendes einer Strangleitung mit dem Eingangsmodul ist der Schnellverbinder des Eingangsmoduls insbesondere mit einer von der Außenseite der Seitenwand des Anschlusskastengehäuses im Bereich der Öffnungen bedienbaren Anschlusseinrichtung, beispielsweise einer Federkraftklemme, einer Zugfeder oder einer Schraubklemme, ausgerüstet, um das abisolierte Leiterende der Strangleitung zu kontaktieren, ohne die Frontabdeckung des Anschlusskastengehäuses öffnen zu müssen.

Beispielsweise kann eine Zugentlastung der Strangleitung in dem Schnellverbinder integriert sein, so dass beim Verbinden automatisch eine Zugentlastung geschaffen wird, insbesondere mittels einer Rastverbindung. Alternativ kann eine Befestigung der Strangleitung an der Außenseite der umlaufenden Seitenwand des Generatoranschlusskastens die Funktion der Zugentlastung übernehmen, beispielsweise mit Hilfe einer Überwurfmutter, die auf einem an der Öffnung in der umlaufenden Seitenwand angebrachten Außengewinde befestigt wird.

Die Eingangsmodule für den Pluspol und den Minuspol sind insbesondere identisch ausgebildet. Ein im Generatoranschlusskasten angeordnetes Eingangsmodul ist entweder an eine Leitung des Pluspols des Photovoltaikgenerators oder an eine Leitung des Minuspols des Photovoltaikgenerators angeschlossen, je nachdem, zu welchem Pol das Eingangsmodul zugeordnet ist. Dadurch können Produktions- und Logistikkosten verringert werden.

In dem Generatoranschlusskasten sind insbesondere mehrere identische Eingangsmodule angeordnet, wobei eine Mehrzahl von Modulen dem Pluspol des Photovoltaikgenerators zugehörig sind, sowie ein bis mehrere Module dem Minuspol des Photovoltaikgenerators zugeordnet sind. Gegebenenfalls können die zu einem Pol des Photovoltaikgenerators zugeordneten Eingangsmodule mittels einer elektrisch leitenden und an Brückenkontakten der Eingangsmodule angebrachten Strombrücke direkt miteinander gebrückt sein, so dass die einzelnen Stränge elektrisch zu einer Einheit verbunden werden. Eine ggf. erforderliche Parallelschaltung der Strangleitungen kann demnach bereits in den Eingangsmodulen stattfinden.

In dem Generatoranschlusskasten ist ggf. ein Haupttrennschalter zum Trennen des Photovoltaikgenerators vom Stromnetz bzw. von weiteren Bauteilen, wie Wechselrichtern, angeordnet. Weist das Anschlusskastengehäuse keine Tür auf, so kann der Haupttrennschalter auch im Außenbereich, beispielsweise an der umlaufenden Seitenwand, des Generatoranschlusskastens angeordnet sein. Somit ist in jedem Fall der einfache Zugriff auf den Haupttrennschalter gegeben.

Der Generatoranschlusskasten umfasst bevorzugt Montagemittel, beispielsweise eine Montageplatte oder eine Montageschiene, im Anschlusskastengehäuse, an der die Eingangsmodule und ggf. weitere im Generatoranschlusskasten anzuordnende Module zu befestigen sind, z.B. aufgerastet werden. Beim Montieren der Eingangsmodule auf das Montagemittel positionieren sich die in den Eingangsmodulen integrierten Schnellverbinder automatisch in oder unmittelbar an den Öffnungen der umlaufenden Seitenwand.

Die Montageschiene ist insbesondere eine Hutschiene, auf der die Eingangsmodule aufrastbar sind und beim Aufrasten auf die Hutschiene die in den Eingangsmodulen integrierten Schnellverbinder automatisch in oder unmittelbar an den Öffnungen des Generatoranschlusskastens zu liegen kommen.

Die Eingangsmodule und die Montageschiene weisen bevorzugt eine Linearführung auf, mittels welcher die Eingangsmodule von oben herab linear an die zugehörige Öffnung in der Seitenwand geführt werden. Ggf. greifen dabei rückwandseitig an den Eingangsmodulen befindliche Verbindungshaken in Aufnahmen der Montageschiene ein. Mittels der Verbindungshaken ist demnach eine lineare Führung der Eingangsmodule senkrecht zum unteren Teil der umlaufenden Seitenwand realisiert, so dass die Schnellverbinder gerade in die Öffnungen der umlaufenden Seitenwand eingeführt werden. Die Verbindungshaken sowie die Aufnahmen der Montageschiene sind bevorzugt nach unten verjüngend ausgebildet, so dass eine genaue Positionierung bzw. Zentrierung der Eingangsmodule erreicht wird.

In einer bevorzugten Ausführungsform greifen die rückwandseitig an den Eingangsmodulen angeordneten Verbindungshaken in oder unter die Aufnahmen der Montageschiene, so dass zwischen den Verbindungshaken und den Aufnahmen eine Klemmwirkung zur Fixierung der Eingangsmodule entsteht.

Bevorzugt greift daher beim Montieren des Eingangsmoduls in dem Generatoranschlusskasten der Schnellverbinder in die Öffnung in der umlaufenden Seitenwand ein oder kommt daran zur Anlage, so dass das Eingangsmodul mit dem Aufstecken oder Aufrasten auf die Montageschiene fertig in dem Generatoranschlusskasten montiert ist.

Die Strangleitungen und die Schnellverbinder der Eingangsmodule weisen vorzugsweise komplementäre Verbindungsmittel auf, beispielsweise eine Schraubverbindung, so dass die Eingangsmodule beim Befestigen der Strangleitung automatisch an der Seitenwand des Anschlusskastengehäuses befestigt werden. Dadurch kann ggf. auf eine Befestigung der Eingangsmodule an der Generatoranschlusskastenrückwand verzichtet werden.

Der Schnellverbinder am Eingangsmodul ist insbesondere ein Steckverbinder, welcher mit einem komplementären Steckverbinder der jeweiligen Strangleitung steckbar verbindbar ist. Zum Anschließen der Strangleitung an das Eingangsmodul erstreckt sich der erfindungsgemäße Steckverbinder des Eingangsmoduls oder der Generatorstrangleitung durch die Öffnung in der umlaufenden Seitenwand des Anschlusskastengehäuses. In beiden Fällen kann die Verbindung, insbesondere die Steckverbindung, der Strangleitung mit dem Eingangsmodul ohne weitere Maßnahmen, wie beispielsweise Öffnen der Anschlusskastentür oder Verlegen der Strangleitungen im Geräteanschlusskasten, realisiert werden. Dies stellt eine bedeutende Verkürzung der für den Aufbau der Verbindung benötigten Montagezeit dar.

Ein Steckverbinder zur Verwendung als Schnellverbinder ist z.B. das Produkt SunClix® der Anmelderin. Der Steckverbinder SunClix® weist einen mittels eines dielektrischen Gehäuses wassergeschützten elektrischen Kontakt und eine in einem Haltegestell verrastbare Klemmfeder auf. Weitere Details, insbesondere zur Steckgeometrie, ergeben sich aus der DE 10 2008 061 268 A1.

In einer Ausführungsform der Erfindung sind die Eingangsmodule unmittelbar an der umlaufenden Seitenwand befestigt, wodurch auf eine Befestigung an der Rückwand oder an einem Montagemittel verzichtet werden kann.

Beispielsweise weist die umlaufende Seitenwand für eine Befestigung der Eingangsmodule im Bereich der Öffnungen außenseitige Befestigungsmittel auf, mittels welchen die Schnellverbinder der Eingangsmodule in den Öffnungen in der umlaufenden Seitenwand befestigt werden. Solche Befestigungsmittel sind beispielsweise Rast- oder Klemmmittel, welche ggf. in entsprechende Gegenstücke am Schnellverbinder greifen, oder eine Gewindehülse. So kann das außenseitige Befestigungsmittel an der umlaufenden Seitenwand ein Außengewinde auf einer kragenartig die Öffnung umschließenden Ausstülpung sein, auf welches eine Überwurfmutter aufgeschraubt wird. Die außenseitig an den Öffnungen der umlaufenden Seitenwand angebrachten Befestigungsmittel übernehmen in dieser Ausführungsform die Zugentlastung der Strangleitungen an den Eingangsmodulen. Ein solches Befestigungsmittel kann zudem einen Dichtungsring zum wassergeschützten Abdichten der Durchführung durch die umlaufende Seitenwand des Generatoranschlusskastens aufweisen. Somit wird die Öffnung bereits bei der Verbindung mittels der Befestigungsmittel automatisch abgedichtet.

In einem weiteren Beispiel für eine Befestigung der Eingangsmodule unmittelbar an der umlaufenden Seitenwand weisen die Schnellverbinder der Eingangsmodule Rastaufnahmen, Rasthaken oder eine Gewindehülse auf. Der Schnellverbinder des Eingangsmoduls wird dabei in die Öffnung der umlaufenden Seitenwand geführt, so dass das Eingangsmodul an der Seitenwand zur Anlage kommt, und die Überwurfmutter von außen auf das nach außen ragende Außengewinde des Schnellverbinders geschraubt, um damit das Eingangsmodul mit der Seitenwand zu verschrauben.

Das Eingangsmodul zum Einbau in den Generatoranschlusskasten für die Photovoltaikanlage umfasst demnach einen integrierten Schnellverbinder zum direkten Verbinden der elektrischen Strangleitung der Photovoltaikanlage mit dem Eingangsmodul, wobei der Schnellverbinder beim Montieren des Eingangsmoduls in den Generatoranschlusskasten in oder unmittelbar an der zugeordneten Öffnung in der umlaufenden Seitenwand des Anschlusskastengehäuses zu liegen kommt. Mit anderen Worten kommt das Eingangsmodul bei der Montage an der Seitenwand zur Anlage oder greift in die Öffnung der Seitenwand ein, derart dass der direkte Anschluss der Strangleitung von außerhalb an das im Innern des Anschlusskastengehäuses angeordnete Eingangsmodul ermöglicht ist.

Das Eingangsmodul ist in vorteilhafter Weise dazu ausgebildet, eine Mehrfachfunktion zu erfüllen, die zusätzlich zum Anschließen der Strangleitung zumindest eine weitere Funktion ausführt. Hierzu weist das Eingangsmodul gemäß der Erfindung eine Aufnahme für ein Funktionselement auf. Das Funktionselement ist z.B. eine Sicherung, ein Strommessbauteil, ein Spannungsdetektor oder ein Mikrokontroller, welche in die Funktionselementaufnahme eingesetzt werden. Der Spannungsdetektor ist entweder ein Überspannungsdetektor, z.B. als Blitzschutz, oder ein Unterspannungsdetektor zur Vermeidung von Hot Spots, wobei außerhalb von Schwellwerten liegende Spannungsabweichungen erkannt werden und die elektrische Verbindung beim Vorliegen von Spannungsabweichungen unterbrochen wird.

Gemäß einer bevorzugten Ausführungsform ist die Funktionselementaufnahme derart ausgebildet, dass das Funktionselement an dem Eingangsmodul austauschbar ist. Die Funktionselementaufnahme für ein austauschbares Funktionselement erhöht die Flexibilität der in den Generatoranschlusskasten einzusetzenden Eingangsmodule, da jedes Eingangsmodul mit dem benötigten Funktionselement bestückt und in den Generatoranschlusskasten eingesetzt werden kann.

Die Funktionselementaufnahme kann sogar derart ausgestaltet sein, dass verschiedene Funktionselemente im Wechsel in dieselbe Funktionselementaufnahme einsetzbar sind. Dies vereinfacht Produktionsabläufe und erhöht die Stückzahlen von identisch herzustellenden Eingangsmodulen, was wiederum die Stückkosten senken kann.

Das Eingangsmodul weist besonders bevorzugt mehrere Funktionselementaufnahmen auf, um in ein und dasselbe Eingangsmodul mehrere, insbesondere unterschiedliche Funktionselemente einzusetzen. Hierdurch kann vorteilhafter Weise die Anzahl der Module im Generatoranschlusskasten und die Anzahl elektrischer Verbindungsleitungen auf ein Minimum reduziert werden. Überdies lässt sich die Baugröße des Generatoranschlusskastens weiter verkleinern.

Das Eingangsmodul umfasst vorzugsweise eine seitlich angeordnete paarbare Verbindungseinrichtung zum wechselseitigen Verbinden von zwei oder mehr Eingangsmodulen, um mehrere Eingangsmodule als eine Einheit in den Generatoranschlusskasten einzusetzen und dort zu befestigen. Die verbundenen Eingangsmodule werden z.B. als Einheit auf die Hutschiene aufgerastet, wobei die primärseitig integrierten Schnellverbinder der Eingangsmodule automatisch jeweils an oder in der zugehörigen Öffnung des Anschlusskastengehäuses zu liegen kommen. Darüber hinaus kann ein ggf. angebrachter Bus-Anschluss in der seitlich angeordneten paarbaren Verbindungseinrichtung integriert sein.

Wenn die Eingangsmodule direkt an der umlaufenden Seitenwand des Anschlusskastengehäuses befestigt sind, kann vorteilhafter Weise auf eine Befestigung an der Gehäuserückwand verzichtet werden.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: einen bekannten Generatoranschlusskasten mit herkömmlichen Modulen und einem Haupttrennschalter,
- Fig. 2: eine Ausführungsform eines erfindungsgemäßen Generatoranschlusskastens mit fünf Eingangsmodulen und Haupttrennschalter,
- Fig. 3: eine Ausführungsform des Generatoranschlusskastens mit acht Eingangsmodulen,
- Fig. 4: eine Ausführungsform des Generatoranschlusskastens mit vier Eingangsmodulen und einer Montageschiene,
- Fig. 5: die Ausführungsform wie Fig. 4 mit zwei montierten Eingangsmodulen,
- Fig. 6: die Ausführungsform wie Fig. 4 mit drei montierten Eingangsmodulen,
- Fig. 7: die Ausführungsform wie Fig. 4 mit vier montierten Eingangsmodulen,
- Fig. 8: eine weitere Ausführungsform des Generatoranschlusskastens mit acht montierten Eingangsmodulen sowie alternativen Strangleitungsanschlüssen,
- Fig. 9: einen Generatoranschlusskasten mit weiteren Ausführungsformen von Eingangsmodulen.

### Detaillierte Beschreibung der Figuren

Figur 1 zeigt einen bekannten Generatoranschlusskasten 2 mit einem Anschlusskastengehäuse 4, welches eine umlaufende Seitenwand 6 sowie eine Rückwand 5 aufweist. Die umlaufende Seitenwand 6 weist Öffnungen 8 zum Durchführen von Strangleitungen 24 auf. Im Inneren des Generatoranschlusskastens 2 sind verschiedene Module, die Eingangsmodule 10a, das Messmodul 32, Verbindungsmodul 34 und weitere Module 36, beispielsweise ein Überspannungsschutzmodul, sowie ein Haupttrennschalter 38 angeordnet.

An die in der Figur 1 links dargestellten Eingangsmodule 10a für den Pluspol sind fünf Strangleitungen 24 angeschlossen.

Die in Figur 1 gezeigten Strangleitungen werden einzeln durch Öffnungen 8 der umlaufenden Seitenwand hindurchgeführt und im Inneren des Generatoranschlusskastens 2 an Eingangsmodule 10a mittels Schraubverbindung angeschlossen. Die Eingangsmodule 10a entsprechen in dem gezeigten Beispiel einfachen Anschlussterminals.

Die Leitungen des einen elektrischen Pols der Photovoltaikanlagenstränge, üblicherweise des Pluspols, sind mittels elektrischen Messmodulleitungen 31 nach den Eingangsmodulen 10a mit einem zur installierten Strangzahl passenden Messmodul 32 zur Messung der Strangleitungsströme verbunden.

Mittels der Brückungsmodulleitungen 33 ist das Messmodul 32 wiederum an Brückungsmodule 34 angeschlossen zur Brückung und somit zur Sammlung der Einzelstrangströme. Der gesammelte Strom wird schließlich über eine Trennschalterleitung 37 zu einem Haupttrennschalter 38 geführt und üblicherweise anschließend über eine Netzleitung 25 zu einem Netzwechselrichter (nicht dargestellt) geleitet.

Der Stromfluss des anderen elektrischen Pols der Photovoltaikanlage, üblicherweise des Minuspols, wird im gezeigten Fall ausgangsseitig der Eingangsmodule 10a über eine elektrische Leitung 35 zu einem weiteren Modul 36 und anschließend über eine Trennschalterleitung 37 zum Haupttrennschalter 38 geführt.

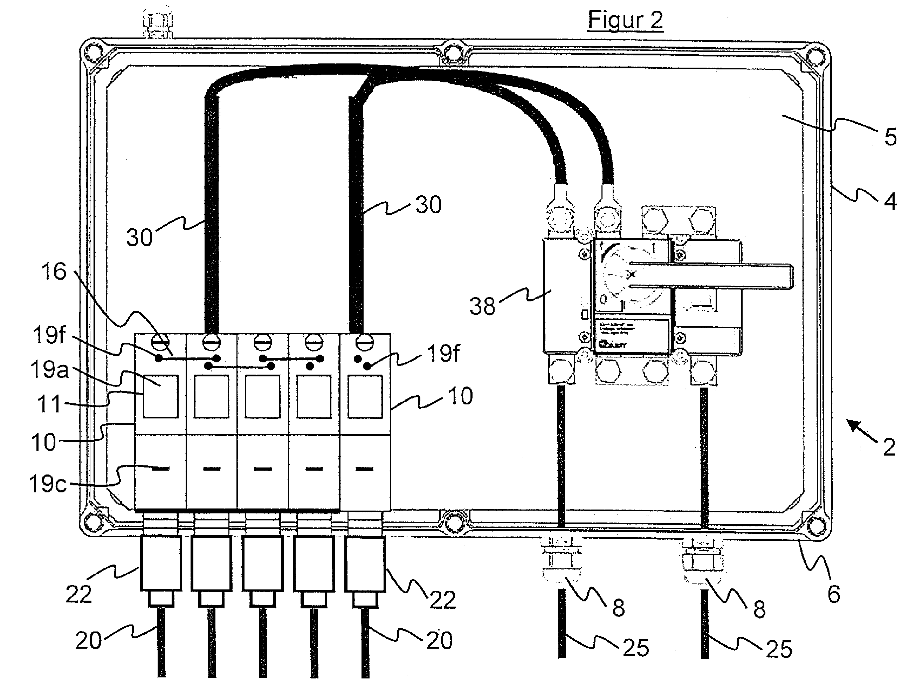

Figur 2 zeigt eine erste Ausführungsform unter Verwendung der erfindungsgemäßen Eingangsmodule 10 in einem Generatoranschlusskasten 2, wobei der Aufbau der Figur 2 wesentliche Unterschiede zu dem Generatoranschlusskasten in Figur 1 veranschaulicht. Die Eingangsmodule 10 mit ihren Schnellverbindern 12 (in der gezeigten Ausführung jeweils vom komplementären Schnellverbinder 22 der Strangleitung 20 verdeckt) sind unmittelbar an der umlaufenden Seitenwand 6 des Anschlusskastengehäuses 4 angeordnet, so dass die Strangleitungen 20 direkt von außen an der Seitenwand 6 an die Schnellverbinder 12 der Eingangsmodule 10 angeschlossen sind, ohne dass dafür die Strangleitungen 20 oder andere elektrische Leitungen im inneren Bereich des Generatoranschlusskastens 2 zu verlegen sind.

Die Eingangsmodule 10 weisen in der gezeigten Ausführungsform mehrere Funktionselementaufnahmen 11 auf zur Aufnahme je eines Sicherungselements 19c und eines Strommessbauteils 19a. Je zwei Brückenkontakte 19f sind elektrisch gesehen hinter dem Strommessbauteil 19a an den Eingangsmodulen 10 angeordnet zum paarweisen Brücken der Eingangsmodule mittels Strombrücken 16, um die Einzelstrangströme zu sammeln und gebündelt über eine elektrische Sammelleitung 30 zum Haupttrennschalter 38 zu führen. Mit anderen Worten können die Photovoltaikstränge bereits in den Eingangsmodulen 10 parallel geschaltet werden. In vorteilhafter Weise lassen sich somit nicht nur die Strangleitungen 20 mittels der Schnellverbinder 12 schnell und einfach an die Eingangsmodule 10 anschließen, sondern es werden auch mehrere Funktionen in einem Modul integriert, was den Innenaufbau eines Generatoranschlusskastens 2 vereinfacht. Das Eingangsmodul 10 bildet demnach ein Kombinationsmodul zum Anschließen der Strangleitung, zum Messen einer Messgröße, z.B. Strom, und zum Brücken der parallelen Strangleitungen.

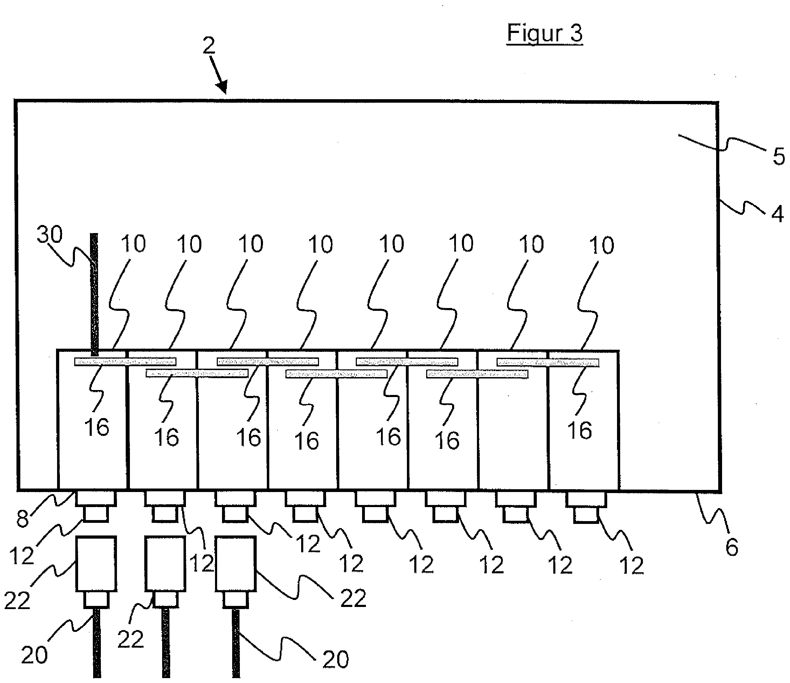

Figur 3 zeigt eine vereinfachte Ausführungsform des Generatoranschlusskastens 2 mit einem Anschlusskastengehäuse 4, welches eine umlaufende Seitenwand 6, eine Rückwand 5 sowie eine Vorderseite (nicht dargestellt) aufweist. Die umlaufende Seitenwand 6 weist Öffnungen 8 auf, die für die Durchführung von Schnellverbindern 12 der Eingangsmodule 10 bzw. Schnellverbindern 22 der Strangleitungen 20 vorgesehen sind.

Im Inneren des Generatoranschlusskastens 2 sind die Eingangsmodule 10 unmittelbar an der umlaufenden Seitenwand 6 des Anschlusskastengehäuses 4 angeordnet, wobei die Schnellverbinder 12 der Eingangsmodule 10 in den Öffnungen in der umlaufenden Seitenwand 6 des Anschlusskastengehäuses 4 zu liegen kommen.

Die Schnellverbinder 22, die am Ende der Strangleitung 20 angeordnet sind, sind komplementär verbindbar mit den Schnellverbindern 12 der Eingangsmodule. Mittels der Schnellverbinder 22 sind die Strangleitungen 20 schnell und komfortabel mit den Eingangsmodulen 10 im Generatoranschlusskasten 2 verbindbar.

Die Eingangsmodule 10 sind miteinander mittels Strombrücken 16 elektrisch verbunden, indem die Strombrücken 16 je an einem Brückenkontakt 19f des Eingangsmoduls 10 angeschlossen sind. Eine elektrische Sammelleitung 30 führt den gesammelten Strom von den Eingangsmodulen ab.

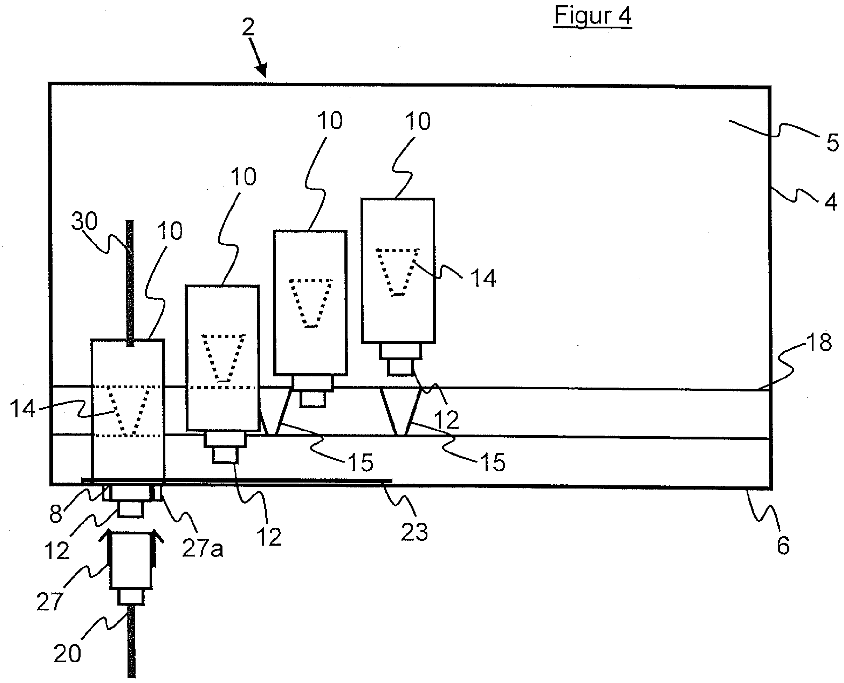

Figuren 4 bis 7 zeigen eine einfache Ausgestaltung eines Generatoranschlusskastens mit einem Montagemittel in Form einer Montageschiene 18. Wie in Figur 4 ersichtlich, weisen die Eingangsmodule 10 rückwandseitig einen sich verjüngenden Verbindungshaken 14 auf. Dieser Verbindungshaken 14 des Eingangsmoduls 10 ist in Aufnahmen 15 der Montageschiene 18 mittels einer Linearbewegung von, in Bildrichtung, oben nach unten einführbar. Somit wird durch die Verbindungshaken eine Linearführung der Module mit Zentrierung gewährleistet, um die Schnellverbinder 12 mit einer einzigen Handbewegung sicher in die Öffnungen 8 des Anschlusskastengehäuses 4 einzuführen. So ist das in Figur 4 links dargestellte Eingangsmodul 10 bereits in der Endposition an der Montageschiene 18 angeordnet, wobei der Verbindungshaken 14 in die Aufnahme 15 an der Montageschiene eingeführt ist. Wenn der Verbindungshaken 14 derart ausgebildet ist, dass er teilweise unter die Aufnahme 15 der Montageschiene 18 greift (nicht dargestellt), kann eine Klemmkraft zwischen dem Verbindungshaken 14 des Eingangsmoduls 10 und der Aufnahme 15 der Montageschiene 18 das Eingangsmodul 10 in der Aufnahme 15 fixieren.

In dem gezeigten Beispiel sind als Schnellverbinder 12 der Eingangsmodule bzw. Schnellverbinder 22 der Strangleitung 20 SunClix®-Verbinder der Anmelderin skizziert. Die SunClix®-Verbinder weisen Rasthaken 27 auf, die im montierten Zustand in am Eingangsmodul 10 angeordnete Rastaufnahmen 27a eingreifen und somit durch Verrastung eine sichere Verbindung herstellen.

Die Strangleitung 20 ist mit den Rasthaken 27 an den Rastaufnahmen 27a des Eingangsmoduls 10 zugentlastet. Drei weitere Eingangsmodule 10 sind in einem noch nicht montierten Zustand im Generatoranschlusskasten 2 gezeigt.

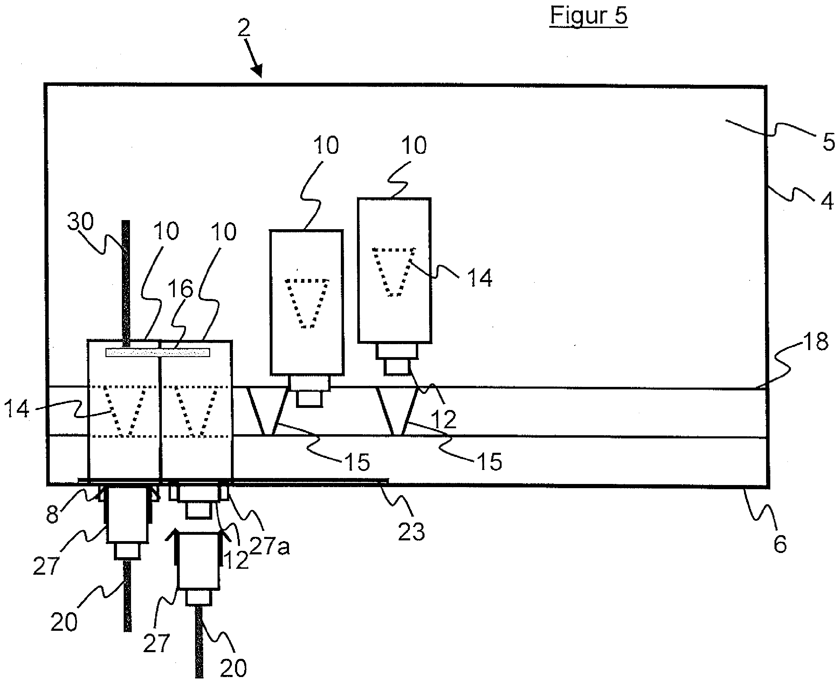

Figur 5 zeigt die Ausführungsform wie Figur 4, wobei Eingangsmodule und Strangleitungen ebenfalls mit den SunClix®-Verbindern ausgerüstet sind, und wobei bereits ein zweites Eingangsmodul 10 mit dem rückwandseitigen Verbindungshaken 14 an der Montageschiene befestigt ist und dabei gleichfalls mit dem Schnellverbinder 12 unmittelbar in der Öffnung 8 der umlaufenden Seitenwand 6 des Generatoranschlusskastengehäuses 4 zu liegen kommt. Anders ausgedrückt erstreckt sich der Schnellverbinder 12 des Eingangsmoduls 10 durch die Öffnung in der umlaufenden Seitenwand 6 des Anschlusskastengehäuses 4 hindurch. Auch das zweite Eingangsmodul 10 wird mit einer Strangleitung 20 verbunden, beide Eingangsmodule 10 sind mittels einer an einem Brückenkontakt 19f angeschlossenen Strombrücke 16 miteinander elektrisch verbunden. Die Verwendung einer Strombrücke 16 zwischen den Eingangsmodulen 10 gestattet das Verwenden von lediglich einer elektrischen Sammelleitung 30 zum Abführen des von den photovoltaischen Solarmodulen erzeugten elektrischen Stromes von den Eingangsmodulen 10. Auch das zweite Eingangsmodul 10 wird durch das Verbinden der beiden Schnellverbinder 12, 22 an der umlaufenden Seitenwand 6 des Anschlusskastengehäuses 4 befestigt, wodurch eine stabile Montage erfolgt, ohne auf eine zusätzliche Schraub- oder anderweitige Verbindung angewiesen zu sein. Auch ist mittels der Schnellverbinder 22, 12 eine Zugentlastung der Strangleitungen 20 ermöglicht. Die beiden rechten in Figur 5 dargestellten Eingangsmodule 10 befinden sich noch in einem nicht montierten Zustand.

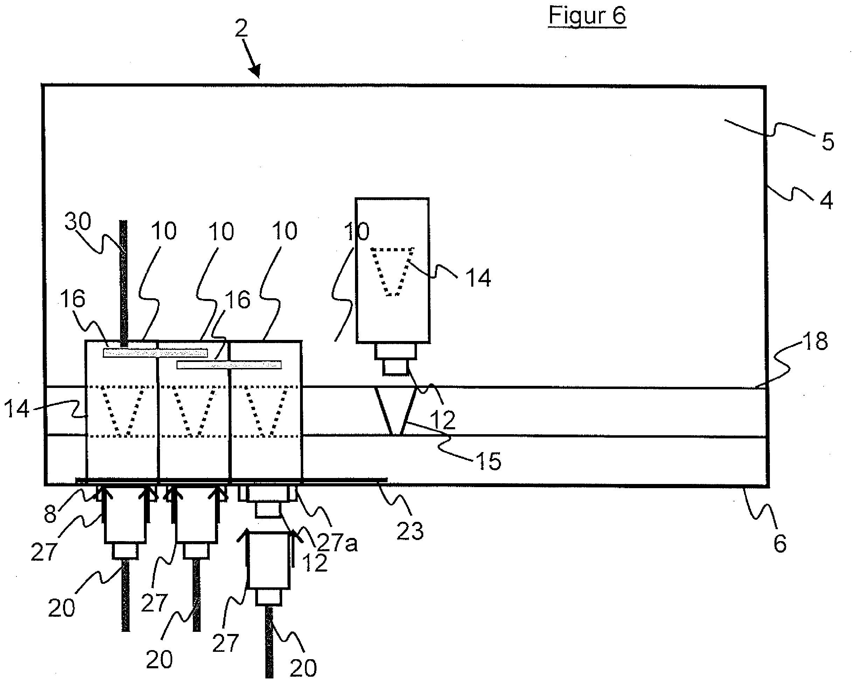

Figur 6 zeigt die Ausführungsform wie Figur 4, wobei bereits drei Eingangsmodule 10 auf eine Montageschiene aufgesteckt sind und unmittelbar in den Öffnungen der umlaufenden Seitenwand 6 des Anschlussgehäusekastens 4 zu liegen kommen. Auch das dritte Eingangsmodul 10 ist mittels eines Brückenkontakts 19f über eine Strombrücke 16 mit den beiden bereits montierten Eingangsmodulen 10 elektrisch verbunden. Das rechte Eingangsmodul 10 befindet sich noch im nicht montierten Zustand.

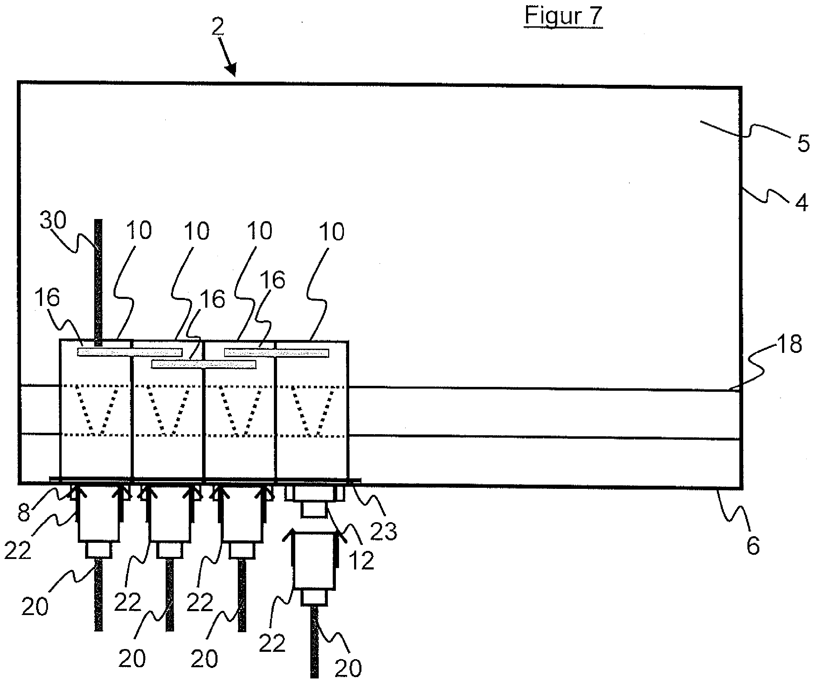

Figur 7 zeigt die Ausführungsform wie Figur 4, wobei alle vier gezeigten Eingangsmodule 10 auf die Montageschiene 18 aufgesteckt sind. Bereits das Aufstecken der Eingangsmodule 10 auf die Montageschiene 18 kann eine zufriedenstellende Fixierung der Eingangsmodule 10 mittels der Klemmkraft der Verbindungshaken 14 in den Aufnahmen 15 der Montageschiene 18 darstellen.

In einer besonderen Ausgestaltung der Schnellverbinder 12, 22 der Eingangsmodule 10 werden die Eingangsmodule 10 befestigt, indem die Schnellverbinder 12, 22 unmittelbar an der die Öffnung 8 umgebenden umlaufenden Seitenwand 6 des Anschlusskastengehäuses 4 befestigt, z.B. verschraubt, geklemmt oder verrastet sind.

An dem Schnellverbinder 22 der Strangleitung 20 ist in dieser Ausführung ein Dichtring (nicht dargestellt) angebracht, so dass beim Verbinden ein wassergeschützter Verschluss der Öffnung 8 und damit des Generatoranschlusskastens 2 erreicht wird. Mit anderen Worten verschließt bereits das Verbinden der Strangleitung 20 mit dem Eingangsmodul 10 über die Schnellverbinder 12, 22 die jeweilige Öffnung 8 des Anschlusskastengehäuses 4 wasserdicht.

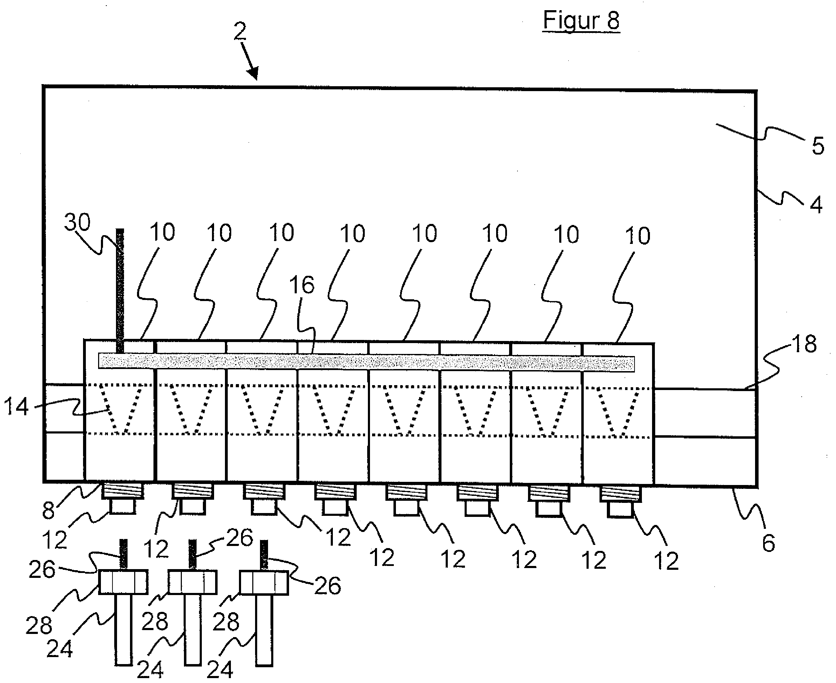

Figur 8 zeigt eine Ausführungsform mit acht auf eine Montageschiene aufgesteckten Eingangsmodulen 10, welche alle mit einer gemeinsamen Strombrücke 16 miteinander elektrisch kontaktiert sind. Ein abisoliertes Leiterende 26 wird in dieser Ausführungsform direkt in die Schnellverbindungsbuchse 12 des Eingangsmoduls 10 gesteckt, eine Überwurfmutter 28 an einem Außengewinde der Buchse 12 festgeschraubt, wodurch gleichzeitig das Eingangsmodul an der Seitenwand befestigt wird und ebenfalls mittels einer Quetschhülse eine feste und zugentlastende Verbindung der Strangleitung 24 mit dem Eingangsmodul 10 gewährleistet ist. Auch in dieser Ausführungsform ermöglicht die Strombrücke 16, dass nur eine elektrische Sammelleitung 30 zum Abführen des elektrischen Stromes benötigt wird. Beispielsweise führt die elektrische Sammelleitung 30 zu einem Haupttrennschalter 38 (vgl. Fig.2), welcher typischerweise ebenfalls im oder am Generatoranschlusskasten angeordnet wird.

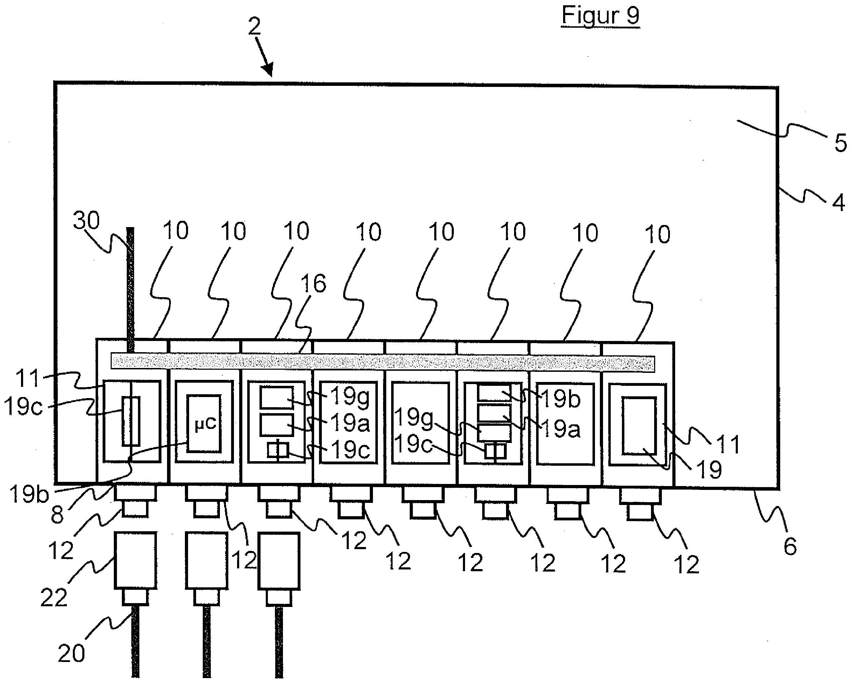

Figur 9 zeigt schließlich eine Ausführungsform des Generatoranschlusskastens 2, wobei die Eingangsmodule 10 unmittelbar an der umlaufenden Seitenwand 6 des Anschlusskastengehäuses 4 angeordnet sind und dort direkt befestigt werden. Eine Montageschiene ist in dieser Ausführungsform nicht vorgesehen. Die Eingangsmodule 10 sind über eine Strombrücke 16 elektrisch miteinander verbunden. Die Eingangsmodule 10 weisen Aufnahmen 11 für Funktionselemente 19 auf. Für die Anordnung der Funktionselemente 19 werden verschiedene Möglichkeiten gezeigt, die jeweils verschiedene Ausgestaltungen der Eingangsmodule 10 zeigen. Typischerweise sind zumindest die Eingangsmodule 10 eines elektrischen Pols des Photovoltaikgenerators in derselben Ausgestaltung ausgeführt, so dass allen Strängen dieselben Funktionen zugeordnet sind. Es ist aber auch möglich, eine Kombination von verschiedenen Ausgestaltungen der Eingangsmodule 10 in einem Generatoranschlusskasten 2 vorzusehen.

Im Falle des linken Eingangsmoduls 10 ist eine Sicherung 19c als Funktionselement 19 eingesetzt. Bei dem zweiten Eingangsmodul 10 ist ein Mikrokontroller 19b eingesetzt. Vorteilhaft ist die Anordnung des dritten Eingangsmoduls 10, bei dem eine Sicherung 19c, ein Strommessbauteil 19a und ein Spannungsdetektor 19g integriert in einem Eingangsmodul 10 angeordnet sind. Gemäß dem sechsten Eingangsmodule 10 ist eine Sicherung 19c, ein Spannungsdetektor 19g, ein Strommessbauteil 19a sowie ein Mikrokontroller 19b integriert im Eingangsmodul 10 angeordnet.

Demgemäß ist die Anbringung von mehreren Funktionselementen 19a, 19b, 19c, 19g in den Funktionselementaufnahmen 11 der Eingangsmodule 10 gewährleistet, wodurch sich getrennte Bauteile bzw. mehrere verschiedene Module einsparen lassen, da die erwünschten Funktionen bereits von den Eingangsmodulen 10 erfüllt werden können.

Die Öffnungen 8 in der umlaufenden Seitenwand 6 des Anschlusskastengehäuses 4 werden durch die Schnellverbinder der Eingangsmodule zumindest nach dem Verbinden mit den Schnellverbindern 22 der Strangleitungen 20 wasserdicht verschlossen.

Ein Bus-Anschluss (nicht dargestellt) zur Kommunikation zwischen den Eingangsmodulen, in der gezeigten Ausführungsform beispielsweise zur Kommunikation zwischen dem Strommessbauteil 19a und dem Mikrokontroller 19b und/oder zur Verbindung mit einer Zentralstelle wie einem Arbeitsplatzrechner, kann zusätzlich in allen Eingangsmodulen 10 integriert sein.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne die Erfindung zu verlassen. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind.

### Bezugszeichenliste

- 2: Generatoranschlusskasten
- 4: Anschlusskastengehäuse
- 6: umlaufende Seitenwand des Anschlusskastengehäuses
- 8: Öffnung
- 10: Eingangsmodul
- 10a: Eingangsmodul
- 11: Funktionselementaufnahme
- 12: Schnellverbinder
- 14: rückwandseitiger Verbindungshaken
- 15: Aufnahme der Montageschiene
- 16: Strombrücke
- 18: Montageschiene oder Montageplatte
- 19: Funktionselement
- 19a: Strommessbauteil
- 19b: Mikrokontroller
- 19c: Sicherungselement
- 19f: Brückenkontakt
- 19g: Spannungsdetektor
- 20: Strangleitung
- 22: Schnellverbinder
- 23: Dichtung
- 24: Strangleitung
- 25: Netzleitung
- 26: abisoliertes Leiterende
- 27: Rasthaken des SunClix®-Verbinders
- 27a: Rastaufnahme des SunClix®-Verbinders
- 28: Überwurfmutter
- 30: elektrische Sammelleitung
- 31: Messmodulleitung
- 32: Messmodul
- 33: Brückungsmodulleitung
- 34: Brückungsmodul
- 35: elektrische Leitung
- 36: Weiteres Modul
- 37: Trennschalterleitung
- 38: Haupttrennschalter

## Patentansprüche

1. Generatoranschlusskasten (2) für einen Photovoltaikgenerator, umfassend
ein Anschlusskastengehäuse (4) mit einer Rückwand und einer umlaufenden Seitenwand (6),
Eingangsmodule (10) mit jeweils einem integrierten Schnellverbinder (12) zum Anschließen einer Strangleitung (20, 24) an das zugehörige Eingangsmodul (10),
wobei die Eingangsmodule (10) unmittelbar an der umlaufenden Seitenwand (6) des Anschlusskastengehäuses (4) angeordnet sind derart, dass die Strangleitungen (20, 24) direkt von außen an den Schnellverbinder (12) des zugehörigen Eingangsmoduls anschließbar sind,
**gekennzeichnet durch**
zumindest eine Funktionselementaufnahme (11) zur Aufnahme eines Funktionselements (19) in das Eingangsmodul (10).

2. Generatoranschlusskasten nach vorstehendem Anspruch,
wobei mehrere Eingangsmodule (10) mittels jeweils eines Brückenkontakts (19f) über eine Strombrücke (16) zu einem Stromsammelmodul Pluspol und/oder mehrere Eingangsmodule (10) zu einem Stromsammelmodul Minuspol zusammengeschlossen sind.

3. Generatoranschlusskasten nach einem der vorstehenden Ansprüche,
mit einem in dem Anschlusskastengehäuse (4) angeordneten Haupttrennschalter (38) zum Trennen des Photovoltaikgenerators vom Stromnetz.

4. Generatoranschlusskasten nach einem der vorstehenden Ansprüche,
wobei in dem Anschlusskastengehäuse (4) eine Montageschiene (18) oder Montageplatte (18) zum Befestigen der Eingangsmodule (10) umfasst ist,
wobei die Seitenwand (6) des Anschlusskastengehäuses (4) Öffnungen (8) aufweist und beim Montieren der Eingangsmodule (10) auf die Montageschiene (18) oder Montageplatte (18) die in den Eingangsmodulen (10) integrierten Schnellverbinder (12) in oder unmittelbar an den Öffnungen (8) zu liegen kommen.

5. Generatoranschlusskasten nach vorstehendem Anspruch,
wobei die Montageschiene (18) eine Hutschiene ist, auf der die Eingangsmodule (10) aufrastbar sind und beim Aufrasten auf die Hutschiene die in den Eingangsmodulen (10) integrierten Schnellverbinder (12) in oder unmittelbar an den Öffnungen (8) des Generatoranschlusskastens (2) zu liegen kommen.

6. Generatoranschlusskasten nach Anspruch 4,
wobei die Montageschiene (18) Aufnahmen (15) zur Aufnahme von an den Eingangsmodulen (10) rückwandseitig angeordneten Verbindungshaken (14) (10) aufweist, um die Eingangsmodule (10) mittels der Verbindungshaken (14) an der Montageschiene (18) auszurichten und/oder zu befestigen.

7. Generatoranschlusskasten nach einem der vorstehenden Ansprüche,
wobei der Schnellverbinder (12) am Eingangsmodul (10) als Steckverbinder ausgebildet ist und mit einem komplementären Steckverbinder (22) der jeweiligen Strangleitung (20, 24) steckbar verbindbar ist und
wobei sich der Steckverbinder (12) des Eingangsmoduls (10) durch die Öffnung (8) in der umlaufenden Seitenwand (6) des Anschlusskastengehäuses (4) hindurch erstreckt oder
wobei sich in dem zusammengesteckten Zustand der Steckverbinder (12) der Strangleitung (20, 24) durch die Öffnung (8) in der umlaufenden Seitenwand (6) des Anschlusskastengehäuses (4) hindurch erstreckt.

8. Generatoranschlusskasten nach einem der Ansprüche 1 bis 5,
wobei der Schnellverbinder (12) am Eingangsmodul (10) eine Gewindehülse aufweist und
wobei mittels einer Überwurfmutter (28) an der Strangleitung (20, 24) die Strangleitung an dem Eingangsmodul (10) des Generatoranschlusskastens (2) befestigbar ist, wenn ein abisoliertes Kabelende an dem Eingangsmodul (10) angeschlossen ist.

9. Generatoranschlusskasten nach vorstehendem Anspruch,
wobei die Eingangsmodule Dichtungen (23) zum wassergeschützten Verschließen der Öffnungen (8) umfassen.

10. Eingangsmodul zur Schnellmontage in einem Generatoranschlusskasten nach einem der vorstehenden Ansprüche, umfassend:
einen integrierten Schnellverbinder (12) zum direkten Verbinden mit einer elektrischen Strangleitung (20, 24) einer Photovoltaikanlage mit dem Eingangsmodul (10),
wobei der Schnellverbinder (12) beim Montieren des Eingangsmoduls (10) in den Generatoranschlusskasten (2) in oder unmittelbar an einer Öffnung (8) in der umlaufenden Seitenwand (6) des Anschlusskastengehäuses (4) zu liegen kommt,
**gekennzeichnet durch**
zumindest eine Funktionselementaufnahme (11) zur Aufnahme eines Funktionselements (19) in das Eingangsmodul (10).

11. Eingangsmodul nach vorstehendem Anspruch, wobei das Funktionselement (19) austauschbar an dem Eingangsmodul (10) ausgeführt ist.

12. Eingangsmodul nach vorstehendem Anspruch,
wobei das Funktionselement (19) eine Sicherung (19c), ein Strommessbauteil (19a), ein Mikrokontroller (19b) und/oder ein Spannungsdetektor (19g) ist.

13. Eingangsmodul nach Anspruch 12 ,
wobei mehrere Funktionselementaufnahmen (11) in einem Eingangsmodul (10) integriert sind.

14. Eingangsmodul nach einem der Ansprüche 10 bis 13, ferner umfassend:
paarbare Befestigungsmittel zur gegenseitigen Befestigung von zwei oder mehr Eingangsmodulen (10), um mehrere Eingangsmodule (10) als Einheit auf eine Hutschiene (18) aufzurasten,
wobei die integrierten Schnellverbinder (12) der Eingangsmodule (10) automatisch jeweils an oder in der zugehörigen Öffnung (8) des Anschlusskastengehäuses (4) zu liegen kommen.

## Claims

1. A generator junction box (2) for a photovoltaic generator, comprising
a junction box housing (4) having a rear wall and a circumferential side wall (6);
input modules (10) with a respective integrated quick connector (12) for connecting a string line (20, 24) to the associated input module (10);
wherein the input modules (10) are arranged directly at the circumferential side wall (6) of the junction box housing (4) in such a manner that the string lines (20, 24) can be directly connected to the quick connector (12) of the associated input module from outsize;
**characterized by**
at least one functional element socket (11) for accommodating a functional element (19) in the input module (10).

2. The generator junction box according to the preceding claim,
wherein a plurality of input modules (10) are interconnected to form a current collector module positive terminal and/or wherein a plurality of input modules (10) are interconnected to form a current collector module negative terminal, by means of a respective bridge terminal (19f) via a current bridge (16).

3. The generator junction box according to any one of the preceding claims,
comprising a main circuit breaker (38) arranged in the junction box housing (4) for disconnecting the photovoltaic generator from the power grid.

4. The generator junction box according to any one of the preceding claims,
wherein the junction box housing (4) comprises a mounting rail (18) or mounting plate (18) for fastening the input modules (10);
wherein the side wall (6) of the junction box housing (4) has openings (8) and wherein, when the input modules (10) are mounted onto the mounting rail (18) or mounting plate (18), the quick connectors (12) integrated in the input modules (10) come to rest in or directly at the openings (8).

5. The generator junction box according to the preceding claim,
wherein the mounting rail (18) is a DIN rail onto which the input modules (10) can be snapped, and wherein when being snapped onto the DIN rail, the quick connectors integrated in the input modules (10) come to rest in or directly at the openings (8) of the generator junction box (2).

6. The generator junction box according to claim 4,
wherein the mounting rail (18) has openings (15) for receiving connecting hooks (14) arranged on the rear side of the input modules (10) for aligning and/or fastening the input modules (10) with/to the mounting rail (18) by means of the connecting hooks (14).

7. The generator junction box according to any one of the preceding claims,
wherein the quick connector (12) on the input module is in the form of a plug-in connector and can be mated with a complementary plug-in connector (22) of the respective generator string line (20, 24) by being plugged together;
wherein the plug-in connector (12) of the input module (10) extends through the opening (8) in the circumferential side wall (6) of the junction box housing (4); or
wherein, in the mated state, the plug-in connector (12) of the string line (20, 24) extends through the opening (8) in the circumferential side wall (6) of the junction box housing (4).

8. The generator junction box according to any one of claims 1 to 5,
wherein the quick connector (12) on the input module (10) has a threaded sleeve and wherein the string line (20,24) can be secured to the input module (10) of the generator junction box (2) by means of a coupling nut (28) on the string line (20,24) when a stripped cable end is connected to the input module (10).

9. The generator junction box according to the preceding claim,
wherein the input modules include seals (23) for sealing the openings (8) in watertight manner.

10. An input module for quick installation in a generator junction box according to any one of the preceding claims, comprising:
an integrated quick connector (12) for directly connecting an electrical string line (20,24) of a photovoltaic system to the input module (10);
wherein when the input module (10) is mounted in the generator junction box (2), the quick connector (12) comes to rest in or directly at an opening (8) in the circumferential side wall (6) of the junction box housing (4);
**characterized by**
at least one functional element socket (11) for accommodating a functional element (19) in the input module (10).

11. The input module according to the preceding claim,
wherein the functional element (19) is configured so as to be interchangeable on the input module (10).

12. The input module according to the preceding claim,
wherein the functional element (19) is a fuse (19c), a current measuring component (19a), a microcontroller (19b), and/or a voltage detector (19g).

13. The input module according to claim 12,
wherein an input module (10) has a plurality of functional element sockets (11) integrated therein.

14. The input module according to any one of claims 10 to 13, further comprising:
mateable fastening elements for connecting two or more input modules (10) together for snap-connecting a plurality of input modules (10) on a DIN rail (18), as a unit,
wherein the integrated quick connectors (12) of the input modules (10) automatically come to rest at or in the associated opening (8) of the junction box housing (4).

## Revendications

1. Boîtier de raccordement de générateur (2) pour un générateur photovoltaïque, comprenant une carcasse de boîtier de raccordement (4) avec une paroi arrière et une paroi latérale périphérique (6), des modules d'entrée (10) avec chacun un connecteur rapide intégré (12) pour raccorder une ligne de phase (20, 24) au module d'entrée (10) correspondant, les modules d'entrée (10) étant disposés directement sur la paroi latérale périphérique (6) de la carcasse de boîtier de raccordement (4), de sorte que les lignes de phase (20, 24) peuvent être raccordées directement de l'extérieur au connecteur rapide (12) du module d'entrée correspondant, **caractérisé par** au moins un logement d'élément fonctionnel (11) pour loger un élément fonctionnel (19) dans le module d'entrée (10).

2. Boîtier de raccordement de générateur selon la revendication précédente, plusieurs modules d'entrée (10) étant réunis en forme de module collecteur de courant de pôle positif au moyen chacun d'un contact à pont (19f) par l'intermédiaire d'un pont de courant (16) et/ou plusieurs modules d'entrée (10) étant réunis en module collecteur de courant de pôle négatif.

3. Boîtier de raccordement de générateur selon une des revendications précédentes, comprenant un sectionneur principal (38) disposé dans la carcasse de boîtier de raccordement (4) pour séparer le générateur photovoltaïque du réseau électrique.

4. Boîtier de raccordement de générateur selon une des revendications précédentes, dans la carcasse de boîtier de raccordement (4) étant compris un rail de montage (18) ou une plaque de montage (18) pour fixer les modules d'entrée (10), la paroi latérale (6) de la carcasse de boîtier de raccordement (4) comportant des ouvertures (8) et, lors du montage des modules d'entrée (10) sur le rail de montage (18) ou sur la plaque de montage (18), les connecteurs rapides (12) intégrés dans les modules d'entrée (10) venant se positionner dans ou directement contre les ouvertures (8).

5. Boîtier de raccordement de générateur selon la revendication précédente, le rail de montage (18) étant un rail chapeau sur lequel les modules d'entrée (10) sont encliquetables et, lors de l'encliquetage sur le rail chapeau, les connecteurs rapides (12) intégrés aux modules d'entrée (10) venant se positionner dans ou directement contre les ouvertures (8) de la boîtier de raccordement de générateur (2).

6. Boîtier de raccordement de générateur selon la revendication 4, le rail de montage (18) comportant des logements (15) pour loger des crochets de liaison (14) (10) disposés à l'arrière sur les modules d'entrée (10) afin d'orienter et/ou de fixer les modules d'entrée (10) sur le rail de montage (18) au moyen des crochets de liaison (14).

7. Boîtier de raccordement de générateur selon une des revendications précédentes, le connecteur rapide (12) sur le module d'entrée (10) étant conformé en connecteur enfichable et pouvant être connecté par enfichage avec un connecteur enfichable complémentaire (22) de la ligne de phase correspondante (20, 24), et le connecteur enfichable (12) du module d'entrée (10) traversant l'ouverture (8) ménagée dans la paroi latérale périphérique (6) de la carcasse de boîtier de raccordement (4) ou, à l'état raccordé, le connecteur enfichable (12) de la ligne de phase (20, 24) traversant l'ouverture (8) ménagée dans la paroi latérale périphérique (6) de la carcasse de boîtier de raccordement (4).

8. Boîtier de raccordement de générateur selon une des revendications 1 à 5, le connecteur rapide (12) sur le module d'entrée (10) comportant une douille filetée, et la ligne de phase (20, 24) pouvant être fixée au module d'entrée (10) du boîtier de raccordement de générateur (2) au moyen d'un écrou-raccord (28) lorsqu'une extrémité de câble dénudée est raccordée au module d'entrée (10).

9. Boîtier de raccordement de générateur selon la revendication précédente, les modules d'entrée comportant des joints (23) pour obturer les ouvertures (8) de manière étanche à l'eau.

10. Module d'entrée pour montage rapide dans un boîtier de raccordement de générateur selon une des revendications précédentes, comprenant un connecteur rapide intégré (12) pour une connexion directe à une ligne de phase électrique (20, 24) d'une installation photovoltaïque avec le module d'entrée (10), le connecteur rapide (12) venant se positionner, lors du montage du module d'entrée (10) dans le boîtier de raccordement de générateur (2), dans ou directement contre une ouverture (8) ménagée dans la paroi latérale périphérique (6) de la carcasse de boîtier de raccordement (4), **caractérisé par** au moins un logement d'élément fonctionnel (11) pour loger un élément fonctionnel (19) dans le module d'entrée (10).

11. Module d'entrée selon la revendication précédente, l'élément fonctionnel (19) étant fixé au module d'entrée (10) de manière échangeable.

12. Module d'entrée selon la revendication précédente, l'élément fonctionnel (19) étant un fusible (19c), un composant de mesure de courant (19a), un microcontrôleur (19b) et/ou un détecteur de tension (19g).

13. Module d'entrée selon la revendication 12, plusieurs logements d'éléments fonctionnels (11) étant intégrés dans un module d'entrée (10).

14. Module d'entrée selon une des revendications 10 à 13, comprenant en outre des moyens de fixation appariables pour la fixation mutuelle de deux ou plusieurs modules d'entrée (10) afin d'encliqueter plusieurs modules d'entrée (10) sous la forme d'une unité sur un rail chapeau (18), les connecteurs rapides intégrés (12) des modules d'entrée (10) venant chacun se positionner automatiquement contre ou dans l'ouverture correspondante (8) de la carcasse de boîtier de raccordement (4).
